# FASCICULE DE BREVET EUROPEEN

(11) **EP 1 723 705 B1**
(45) Date de publication et mention de la délivrance du brevet: **30.05.2012**
(21) Numéro de dépôt: 05717001.1
(22) Date de dépôt: 11.03.2005
(51) Int. Cl.: H01S 5/062, G01S 17/32, G01S 7/491, G01S 17/58

(54) **DISPOSITIF DE DECALAGE DE FREQUENCE DANS UN CHEMIN OPTIQUE A SOURCE LASER CONTINUE**
EINRICHTUNG ZUR FREQUENZVERSCHIEBUNG IN EINEM OPTISCHEN WEG MIT EINER KONTINUIERLICHEN LASERQUELLE
DEVICE FOR SHIFTING FREQUENCY IN AN OPTICAL PATH WITH A CONTINUOUS LASER SOURCE

(30) Priorité: 12.03.2004 FR 0402600
(43) Date de publication de la demande: 22.11.2006
(73) Titulaire: Thales, 92200 Neuilly Sur Seine (FR)
(72) Inventeur: BAILLON, Bertrand, THALES Intellectual Property, F-94117 Arcueil Cedex (FR); SCHLOTTERBECK, Jean-Pierre, THALES Intel. Property, F-94117 Arcueil Cedex (FR); RENARD, Alain, THALES Intellectual Property, F-94117 Arcueil Cedex (FR)
(74) Mandataire: Esselin, Sophie
(86) Numéro de dépôt international: PCT/EP2005/051104
(87) Numéro de publication internationale: WO 2005/099051

(56) Documents cités:
- EP-A- 0 536 783
- EP-A- 1 055 941
- CA-A- 2 476 805
- US-A- 5 847 817
- US-A1- 2002 075 475
- US-A1- 2003 103 211

## Description

La présente invention se rapporte à l'utilisation d'un dispositif de décalage de fréquence dans un chemin optique à source laser à émission continue.

Dans des dispositifs comportant une source laser à émission continue et une détection cohérente hétérodyne, il peut être nécessaire de déterminer une variation de fréquence (effet Doppler) se produisant sur une partie du trajet du faisceau laser et résultant d'un phénomène physique que l'on désire compenser ou mesurer. Ceci est en particulier le cas des Lidars servant à mesurer la vitesse et la direction du vent par rétrodiffusion du faisceau laser sur des aérosols portés par le vent. Cette variation de fréquence est généralement déterminée par mélange du signal reçu avec un signal généré par un oscillateur local et affecté d'un décalage de fréquence permanent qui est produit par un modulateur de type électro-optique ou acousto-optique.

Un tel dispositif modulateur est cher, volumineux et peu discret, car il rayonne en haute fréquence (présence de raies harmoniques de la fréquence fondamentale du signal, susceptibles de perturber le traitement de signal effectué en aval), ce qui risque de limiter la précision de la mesure de vitesse et de rétrécir la fenêtre de mesure spectrale.

On connaît d'après le document CA 2 476 805 un capteur à fibre optique dans lequel un signal lumineux est modulé en fonction de phénomènes physiques agissant sur la longueur d'un chemin optique. Le dispositif de mesure de ce capteur interférométrique reçoit des signaux de modulation impulsionnels décalés en phase sur chacune des deux voies, et mélange les signaux optiques modulés afin d'obtenir un signal d'interférence indicatif de la distance à mesurer. Ce dispositif interférométrique n'a pas de fonction de décalage en fréquence constant et permanent.

Un autre capteur à fibre utilisant l'effet Doppler est connu de US 2002/0075475 A1

La présente invention a pour objet . l'utilisation d'un dispositif de décalage de fréquence dans un chemin optique à source laser à émission continue, avec un dispositif qui soit le moins onéreux possible, peu encombrant, qui ne soit pas une source de rayonnements parasites, et qui puisse s'intégrer dans une architecture comportant des fibres optiques.

Le dispositif utilisé dans l'invention comporte au moins deux modules de décalage en fréquence placés en parallèle et contenant chacun un support de propagation optique dont on modifie la longueur de chemin optique en fonction du décalage de fréquence désiré, chacun de ces modules étant commandé séparément, ce dispositif comportant un commutateur branché aux sorties de ces modules et commandé de façon à choisir, à chaque instant, le module assurant le décalage de fréquence voulu, le commutateur fournissant à sa sortie un faisceau optique continu dont la fréquence est ajustée par tronçons contigus.

Selon une caractéristique avantageuse de l'invention, pour chacun desdits tronçons contigus, l'évolution de la longueur du chemin optique du support de propagation optique est linéaire, cette évolution se faisant grâce à une loi de modulation triangulaire, les pentes des segments ascendants ou descendants de la loi de modulation triangulaire restent identiques dans le temps pendant toute la durée d'application du signal de modulation.

Selon une autre caractéristique avantageuse de l'invention, les pentes des segments ascendants ou descendants varient dans le temps pour obtenir un décalage en fréquence variable, de type « chirp ».

Le support de propagation optique peut être soit une fibre optique, soit un guide d'ondes optique, soit un cristal électro-optique.

Dans le cas où le système dans lequel on fait varier la fréquence est un Lidar, l'évolution de la longueur du chemin optique du support de propagation optique est avantageusement linéaire, et elle est réalisée par évolution linéaire de la contrainte appliquée à la fibre optique ou au guide d'ondes ou de la tension appliquée au cristal électro-optique.

De façon avantageuse, on branche en parallèle au moins deux modules de décalage de fréquence. leurs modulations triangulaires respectives étant identiques et décalées en phase, un commutateur étant branché aux sorties de ces modules et commandé pour recueillir alternativement le faisceau optique dont le décalage en fréquence est constant.

La présente invention sera mieux comprise à la lecture de la description détaillée d'un mode de réalisation, pris à titre d'exemple non limitatif et illustré par le dessin annexé, sur lequel :
- la figure 1 est un bloc-diagramme simplifié d'un Lidar de l'art antérieur, du type cité en préambule,
- la figure 2 est un bloc-diagramme simplifié d'un Lidar comportant un circuit de décalage de fréquence conforme à l'invention, et
- la figure 3 est un bloc-diagramme simplifié d'un exemple d'un ensemble de deux modules de décalage de fréquence conforme à l'invention.

La présente invention est décrite ci -dessous en référence à un Lidar, mais il est bien entendu qu'elle n'est pas limitée à cette seule application, et qu'elle peut être mise en oeuvre dans divers domaines dans lesquels on a besoin de produire un décalage en fréquence sur des fréquences élevées telles que les fréquences supérieures à quelques Ghz.

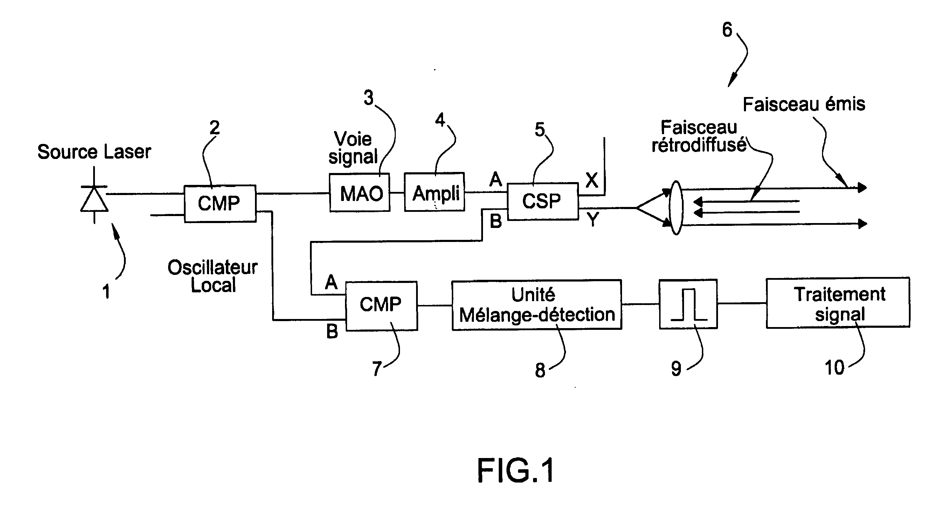

On a représenté sur le bloc-diagramme de la figure 1 une source laser 1 reliée à une entrée d'un coupleur 2 à maintien de polarisation. Une première sortie du coupleur 2, correspondant à la voie « signal », est reliée à un modulateur acousto-optique 3, suivi d'un amplificateur 4. L'amplificateur 4 est relié à une première borne d'un coupleur 5 à séparation de polarisations. Une sortie du coupleur 5 est reliée à un système d'émission-réception de faisceaux Lidar, référencé 6 dans son ensemble. La deuxième sortie du coupleur 2 est reliée à une première entrée d'un coupleur à maintien de polarisation 7, dont l'autre entrée est reliée au coupleur 5. La sortie du coupleur 7 est reliée à une unité de mélange et de détection 8, suivie d'un circuit de filtrage 9 et de circuits 10 de traitement de signal.

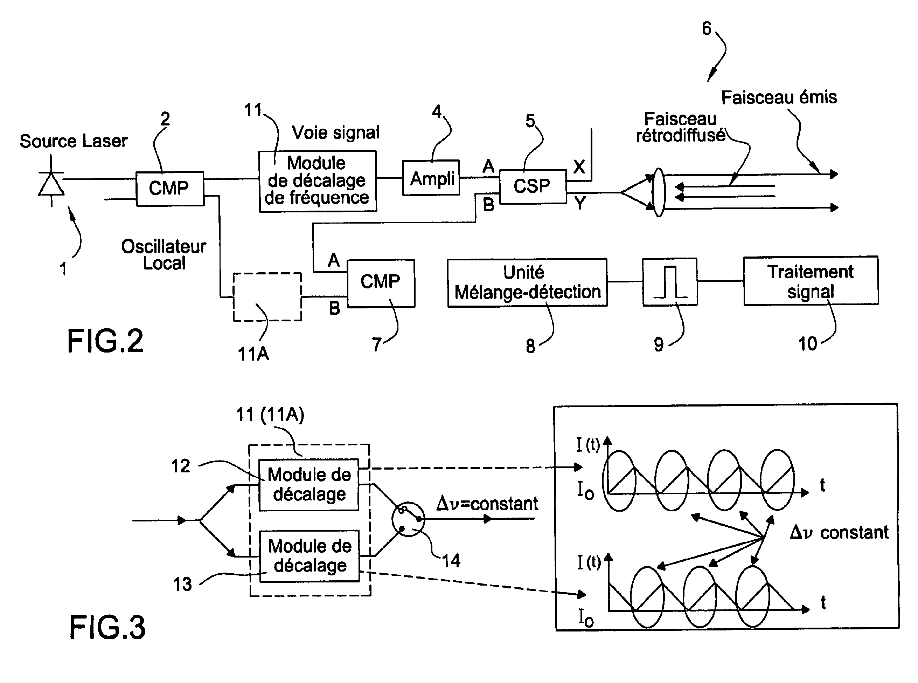

Dans le bloc-diagramme de la figure 2, les éléments similaires à ceux de la figure 1 sont affectés des mêmes références numériques. La différence essentielle entre les systèmes des figures 1 et 2 est que le modulateur 3 de la figure 1 a été remplacé par un dispositif 11 à modules de décalage de fréquence. Les autres éléments du système de la figure 2 peuvent être les mêmes que ceux de la figure 1.

Le dispositif 11 peut comporter un ou plusieurs modules élémentaires de décalage de fréquence. Chacun de ces modules élémentaires comporte un support de propagation optique tel qu'une fibre optique, un guide d'ondes optique ou un cristal électro-optique. On agit sur ce support de façon à en faire varier la longueur du trajet optique. Cette variation de longueur de trajet correspond à une variation d'indice de réfraction du support optique. Dans le cas où ce support est une fibre optique ou un guide d'ondes, cette variation peut être obtenue en imposant une contrainte mécanique au support optique. S'il s'agit d'un cristal électro-optique, la variation est obtenue en appliquant une tension électrique appropriée à ses électrodes. A ce propos, il est important de noter que le cristal électro-optique ne fonctionne alors pas en modulateur électro-optique classique, mais en dispositif provoquant un décalage, fixe ou variable, de la fréquence du faisceau laser qu'il reçoit.

L'évolution de la contrainte mécanique ou de la tension électrique doit, dans le cas présent, être linéaire en fonction du temps. Cette évolution linéaire engendre un décalage Doppler constant, et par conséquent un décalage fixe de fréquence entre les voies « signal » et « oscillateur local », ce qui permet la détection cohérente hétérodyne. Ce décalage Doppler est imposé à la voie « signal » dans laquelle est inséré le dispositif 11 (comme représenté en traits continus sur la figure 2), et/ou dans la voie « oscillateur local » (le deuxième dispositif à modules de décalage est alors référencé 11A et dessiné en traits interrompus sur la figure 2). Une variation de la longueur du chemin optique est engendrée lorsque la vitesse du faisceau traversant le dispositif 11 (et/ou 11A) varie. Cette vitesse varie de manière inversement proportionnelle à l'indice de réfraction du milieu traversé. Selon l'invention, on fait varier linéairement en fonction du temps la longueur du chemin optique dans le dispositif 11 (et/ou 11A), ce qui engendre un décalage Doppler constant

Selon un mode de réalisation avantageux de l'invention, et comme représenté en figure 3, on munit le dispositif 11 (et/ou 11A) de deux modules de décalage identiques 12, 13, branchés en parallèle, et suivis d'un commutateur 14. Il est bien entendu que le dispositif 11 (et/ou 11A) peut comporter plus de deux modules. Dans chacun des modules 12, 13, on applique une modulation triangulaire identique, la modulation dans l'un des deux modules étant décalée en phase, par exemple de π, par rapport à celle de l'autre. Cependant, une telle valeur n'est pas impérative, et il suffit que les deux voies soient décalées d'une demi-période de sorte qu'en sortie de commutateur le décalage fréquentiel soit toujours constant. Les pentes ascendante et descendante de ces modulations triangulaires peuvent être identiques, mais peuvent aussi être différentes, par exemple la pente descendante peut être beaucoup plus forte que l'autre. On n'utilise dans le cas présent que les pentes ascendantes, en basculant alternativement le commutateur 14 à la sortie du module 12 et du module 13. Le décalage de phase entre les deux modulations triangulaires doit être tel que le sommet de la partie ascendante de l'une corresponde au moins au début de la partie ascendante de l'autre. Ainsi, on obtient à la sortie du commutateur 14 un faisceau optique continu dont la fréquence est ajustée par tronçons contigus.

Toutefois, selon une variante de l'invention, on utilise soit un seul module de décalage, le commutateur 14 étant alors supprimé, soit au moins deux modules, mais dans ces deux cas, on n'utilise qu'une partie (ascendante, par exemple) de modulation parmi n consécutives, de même sens de variation (n pouvant être supérieur à 2 ou même à 10). Une telle caractéristique nécessite l'interruption de l'émission du faisceau laser pendant la génération des parties de modulation non utilisées (parties ascendantes et/ou descendantes), mais permet de réaliser un levée de doute en attendant l'arrivée de l'écho réel, correspondant à une portion de faisceau laser émise pendant une partie de modulation ascendante, avant d'émettre la portion de faisceau suivante.

Selon une variante de l'invention, on fait passer deux ou plusieurs fois le faisceau laser dans le dispositif de décalage. Le première raison est d'ordre économique : si la pente en tension appliquée n'est pas suffisante pour obtenir le décalage voulu sur la durée de l'impulsion, on fait traverser une nouvelle fois au faisceau le module pour atteindre le décalage final désiré. La deuxième raison est que le module de décalage pourrait très bien être situé derrière le coupleur 5, juste avant l'émission du faisceau dans l'atmosphère, auquel cas le faisceau rétrodiffusé pourrait subir lui-même un décalage (identique ou inverse ou autre que le décalage initial).

Le décalage de fréquence généré par le dispositif 11 (et/ou 11A) peut être contrôlé à l'aide de la valeur de la mesure du décalage à la sortie de chaque module de décalage. La tension de commande électro-optique ou la contrainte mécanique appliquée au support de propagation optique de ces modules (donc la pente et la forme de la modulation correspondante, et par conséquent la loi d'évolution du décalage de fréquence) peut alors être asservie à une valeur fixe ou évoluant selon une loi déterminée qui est fonction de l'application considérée, comme par exemple dans le cas où se produisent des phénomènes de « narcisse » (réflexions parasites). Cette mesure de décalage de fréquence peut être utilisée dans le post-traitement effectué dans les circuits de traitement de signal du signal rétro-diffusé. L'invention est également applicable lorsque l'on effectue des mélanges en BLU (en phase et en quadrature de phase).

Les applications de l'invention sont nombreuses : outre l'application considérée ici aux Lidars de télémétrie et de vélocimétrie, avec, le cas échéant des faisceaux « chirpés », on citera les télécommunications (multiplexeurs et démultiplexeurs, par exemple, etc.)

Le dispositif utilisé dans l'invention, grâce au remplacement du modulateur acousto-optique ou électro-optique classique par un dispositif de décalage à variation de longueur de parcours optique, permet d'éviter l'émission de raies harmoniques gênantes, et d'éviter la production d'une modulation radiofréquence. Les contraintes mécaniques ou électriques mises en jeu dans ce dispositif de décalage sont faibles et donc faciles à produire. Les technologies électro-optiques employées par l'invention sont issues de celles couramment employées en télécommunications, les composants utilisés étant compacts et peu coûteux, car réalisés en technique intégrée. On peut encore réduire les coûts de ces composants en les hybridant sur un guide d'ondes planaire, ce qui réduit le nombre de connexions par fils et fibres optiques.

## Revendications

1. Utilisation d'un dispositif de décalage de fréquence (11, 11A) dans un chemin optique à source laser à émission continue, ce dispositif comportant au moins un module de décalage en fréquence (12, 13) contenant un support de propagation optique dont on modifie la longueur du chemin optique en fonction du décalage de fréquence désiré, **caractérisée en ce que** l'on branche en parallèle au moins deux modules de décalage de fréquence et que leurs modulations respectives sont identiques et décalées en phase, un commutateur (14) étant branché aux sorties de ces modules et commandé pour recueillir alternativement le faisceau optique continu dont le décalage en fréquence est fixe et sans interruptions.

2. Utilisation d'un dispositif de décalage de fréquence selon la revendication 1, **caractérisée en ce que** le système dans lequel on fait varier la fréquence est un Lidar et que l'évolution de la longueur du chemin optique du support de propagation optique est linéaire.

3. Utilisation d'un dispositif de décalage de fréquence selon la revendication 2, **caractérisée en ce que** l'évolution linéaire se fait selon une loi de modulation triangulaire.

4. Utilisation d'un dispositif de décalage de fréquence selon l'une des revendications précédentes, **caractérisée en ce que** l'on n'utilise qu'une partie de modulation parmi n consécutives de même sens de variation pour réaliser une levée de doute à l'arrivée des échos.

5. Utilisation d'un dispositif de décalage de fréquence selon l'une des revendications précédentes, **caractérisée en ce que** la loi d'évolution du décalage de fréquence est asservie à une valeur fixe.

6. Utilisation d'un dispositif de décalage de fréquence selon l'une des revendications 1 à 4, **caractérisée en ce que** la loi d'évolution du décalage de fréquence est asservie à une valeur variable.

7. Utilisation d'un dispositif de décalage de fréquence selon l'une des revendications précédentes, **caractérisée en ce que** le support de propagation optique est l'un des dispositifs suivants : une fibre optique, un guide d'ondes ou un cristal électro-optique.

## Claims

1. Use of a device for shifting frequency (11, 11 A) in an optical path with a continuous-emission laser source, said device comprising at least one frequency shifting module (12, 13) containing an optical propagation support having an optical path length that is modified as a function of the desired frequency shift, **characterised in that** at least two frequency shifting modules are connected in parallel and **in that** their respective modulations are identical and phase shifted, a switch (14) being connected to the outputs of said modules and being controlled so as to alternately gather the continuous optical beam for which the frequency shift is fixed and without interruptions.

2. The use of a frequency shifting device according to claim 1, **characterised in that** the system in which the frequency is varied is a Lidar system and **in that** the evolution of the length of the optical path of the optical propagation support is linear.

3. The use of a frequency shifting device according to claim 2, **characterised in that** the linear evolution occurs according to a triangular modulation rule.

4. The use of a frequency shifting device according to any one of the preceding claims, **characterised in that** only one modulation part from n consecutive parts in the same direction of variation is used in order to resolve any ambiguity on arrival of the echoes.

5. The use of a frequency shifting device according to any one of the preceding claims, **characterised in that** the rule of evolution of the frequency shift is dependent on a fixed value.

6. The use of a frequency shifting device according to any one of claims 1 to 4, **characterised in that** the rule of evolution of the frequency shift is dependent on a variable value.

7. The use of a frequency shifting device according to any one of the preceding claims, **characterised in that** the optical propagation support is one of the following devices: a fibre-optic, a waveguide or an electro-optic crystal.

## Patentansprüche

1. Verwendung einer Vorrichtung zur Frequenzverschiebung (11, 11A) auf einem Lichtweg mit einer Daueremissionslaserquelle, wobei diese Vorrichtung wenigstens ein Frequenzverschiebungsmodul (12, 13) umfasst, das einen optischen Ausbreitungsträger mit einer Lichtweglänge hat, die in Abhängigkeit von der gewünschten Frequenzverschiebung modifiziert wird, **dadurch gekennzeichnet, dass** wenigstens zwei Frequenzverschiebungsmodule parallel geschaltet sind und dass ihre jeweiligen Modulationen identisch und phasenverschoben sind, wobei ein Schalter (14) mit den Ausgängen dieser Module verbunden ist und so gesteuert wird, dass er abwechselnd den kontiuierlichen optischen Strahl mit fester und mit unterbrechungsfreier Frequenzverschiebung erfasst.

2. Verwendung einer Frequenzverschiebungsvorrichtung nach Anspruch 1, **dadurch gekennzeichnet, dass** das System, in dem die Frequenz variiert wird, ein Lidar-System ist, und dadurch, dass die Evolution der Lichtweglänge des optischen Ausbreitungsträgers linear ist.

3. Verwendung einer Frequenzverschiebungsvorrichtung nach Anspruch 2, **dadurch gekennzeichnet, dass** die lineare Evolution gemäß einem Dreicksmodulationsgesetz erfolgt.

4. Verwendung einer Frequenzverschiebungsvorrichtung nach einem der vorherigen Ansprüche, **dadurch gekennzeichnet, dass** nur ein Teil der Modulation von n konsekutiven Teilen in derselben Variationsrichtung zum Auflösen von Ambiguitäten bei der Ankunft der Echos benutzt wird.

5. Verwendung einer Frequenzverschiebungsvorrichtung nach einem der vorherigen Ansprüche, **dadurch gekennzeichnet, dass** das Evolutionsgesetz der Frequenzverschiebung auf einen festen Wert eingestellt wird.

6. Verwendung einer Frequenzverschiebungsvorrichtung nach einem der Ansprüche 1 bis 4, **dadurch gekennzeichnet, dass** das Evolutionsgesetz der Frequenzverschiebung auf einen variablen Wert eingestellt wird.

7. Verwendung einer Frequenzverschiebungsvorrichtung nach einem der vorherigen Ansprüche, **dadurch gekennzeichnet, dass** der Lichtausbreitungsträger eine der folgenden Vorrichtungen ist: eine Faseroptik, ein Wellenleiter oder ein elektrooptischer Kristall.
